Europäisches Patentamt

European Patent Office

Office européen des brevets

(11) Publication number: **0 488 257 A1**

# EUROPEAN PATENT APPLICATION

(21) Application number: **91120331.3**

(22) Date of filing: **26.11.91**

(51) Int. Cl.5: **H03D 7/12**

(30) Priority: **30.11.90 JP 341009/90**

(43) Date of publication of application:
**03.06.92 Bulletin 92/23**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**
Applicant: **FUJITSU VLSI LIMITED**
**1844-2, Kozoji-cho 2-chome**
**Kasugai-shi Aichi 487(JP)**

(72) Inventor: **Fukayama, Minoru**
**37-1, Shirutanicho, Chikusa-ku**
**Nagoya-shi, Aichi 464(JP)**
Inventor: **Tsukahara, Masahiro, c/o Fujitsu**
**VLSI Limited**
**1844-2, Kozoji-cho 2-chome**
**Kasugai-shi, Aichi 487(JP)**

(74) Representative: **Seeger, Wolfgang, Dipl.-Phys.**
**Georg-Hager-Strasse 40**
**W-8000 München 70(DE)**

(54) **Frequency conversion circuit.**

(57) A frequency conversion circuit includes a first transistor (Tr1) having an emitter coupled to a first power supply system (G, $V_{EE}$), a base having a first input signal (IN1, RF) having a first frequency and a first bias signal ($V_{B1}$), and a collector, and a second transistor (Tr2) having an emitter coupled to the first power supply system, a base having a second input signal (IN2, LO) having a second frequency and a second bias signal ($V_{B2}$), and a collector. A third transistor (Tr3) has an emitter connected to the collectors of the first and second transistors, a base receiving a third bias signal ($V_{B3}$); and a collector via which an output signal (Vout, IF) is obtained. A load element (Lo, R3) is connected between the collector of the third transistor and a second power supply system (Vcc, G). A first capacitor (C1, C3) is connected between the base of the third transistor and the first power supply system.

FIG.12

## BACKGROUND OF THE INVENTION

### (1) Field of the Invention

The present invention generally relates to frequency conversion circuits, and more particularly to a frequency conversion circuit which receives a plurality of input signals and generates output signals having predetermined frequencies therefrom.

### (2) Description of the Prior Art

Recently, mobile communication devices have been equipped with various frequency conversion circuits. It is required that such mobile communication devices operate at a low power supply voltage and have low noise, high isolation and low cost.

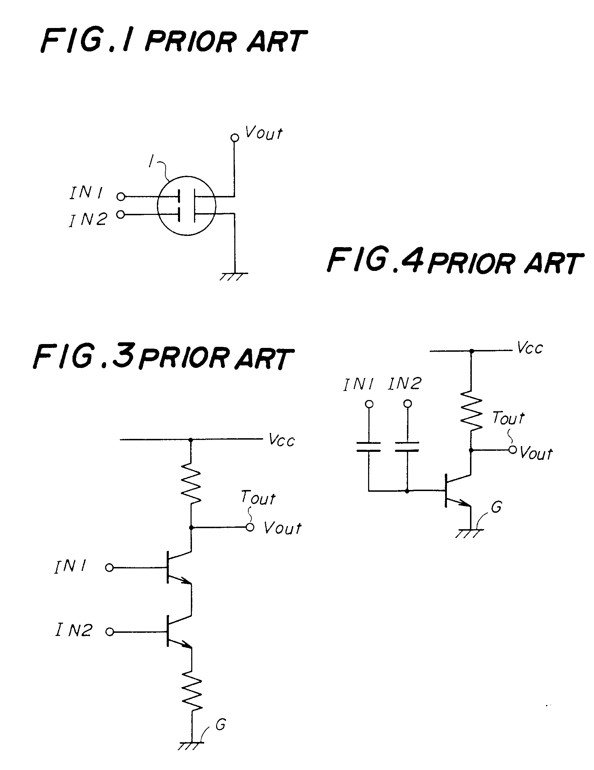

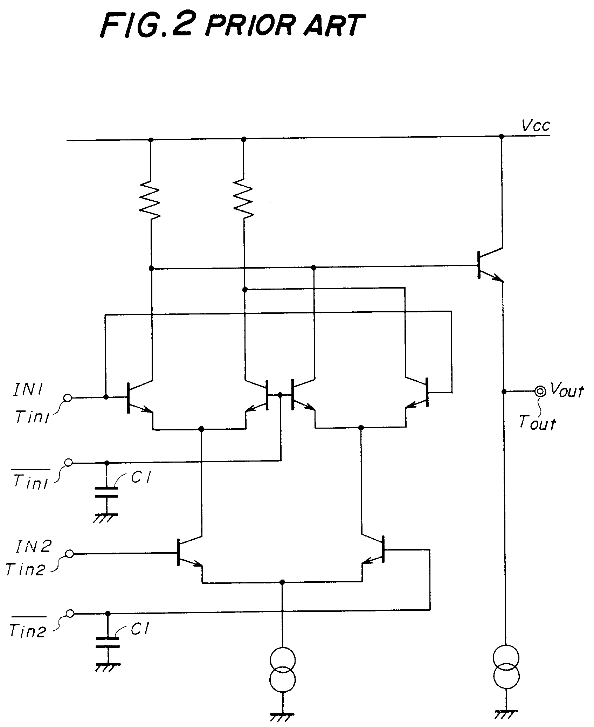

FIG.1 shows a first conventional frequency conversion circuit, which uses a MOS (Metal Oxide Semiconductor) transistor 1. As shown, the MOS transistor 1 has two input terminals to which input signals IN1 and IN2 having different frequencies are respectively applied. The source of the MOS transistor 1 is grounded. An output signal (voltage) Vout obtained via the drain of the MOS transistor 1 includes a first signal component having a frequency equal to the sum of the frequencies of the input signals IN1 and IN2, and a second signal component having a frequency equal to the difference between the frequencies of the input signals IN1 and IN2.

FIG.2 shows a second conventional frequency conversion circuit, which uses differential amplifiers made up of bipolar transistors. The circuit configuration shown in FIG.2 is called a DBM (Double Balanced Mixer) type circuit. Each constant-current source shown in FIG.2 is formed with a bipolar transistor. The input signals IN1 and IN2 are applied to input terminals Tin1 and Tin2, respectively. Input terminals $\overline{\text{Tin1}}$ and $\overline{\text{Tin2}}$ are grounded via capacitors C1. The output voltage Vout obtained at an output terminal Tout includes two signal components as described above.

FIG.3 shows a third conventional frequency conversion circuit, which includes two bipolar transistors connected in series between a power supply line Vcc and ground G. The input signals IN1 and IN2 are applied to the bases of the two bipolar transistors, respectively. The output voltage Vout obtained at the output terminal Tout includes two signal components as described above.

FIG.4 shows a fourth conventional frequency conversion circuit, which includes a single bipolar transistor. The input signals IN1 and IN2 are applied to the base via respective capacitors. The output voltage Vout obtained at the output terminal includes two signal components as described above.

However, the first conventional frequency conversion circuit shown in FIG.1 has a disadvantage in that it does not operate at high frequencies higher than, for example, 100MHz because MOS transistors do not operate at such high frequencies.

The second conventional frequency conversion circuit shown in FIG.2 has a disadvantage in that it has a small noise figure (NF) because a large number of bipolar transistors are used. Further, the circuit configuration shown in FIG.2 is not suitable for use of a low power supply voltage because three transistors are interposed in series between the Vcc line and the ground G. It is necessary to use a power supply voltage Vcc higher than the sum of the base-emitter voltages of the three transistors. If the base-emitter voltages are equal to 0.8V, the power supply voltage Vcc must be higher than 2.4V.

The third conventional frequency conversion circuit shown in FIG.3 is less expensive than the second frequency conversion circuit and is suitable for the low-power supply voltage operation. However, the circuit configuration shown in FIG.3 has a disadvantage in that it is likely to oscillate. The input signal IN1 is amplified by the corresponding transistor (hereinafter referred to as a first transistor), and applied to the collector of the other transistor (hereinafter referred to as a second transistor). The second transistor amplifies the input signal IN1 from the first transistor. The input signal IN1 amplified by the second transistor is applied to the emitter of the first transistor, which amplifies the amplified input signal IN from the second transistor. In this manner, the circuit shown in FIG.3 oscillate.

The fourth conventional frequency conversion circuit shown in FIG.4 has a low noise figure since it uses only one transistor. However, the input signals IN1 and IN2 interfere with each other and leak to the output signal Vout because they are applied to the base of the transistor in common. In other words, the circuit shown in FIG.4 does not have a good isolation between the input signals IN1 and IN2.

## SUMMARY OF THE INVENTION

It is a general object of the present invention to provide a frequency conversion circuit in which the above disadvantages are eliminated.

A more specific object of the present invention is to provide a less expensive frequency conversion circuit which operates by a low power supply voltage and has low noise and high isolation characteristics.

The above objects of the present invention are achieved by a frequency conversion circuit comprising: a first transistor having an emitter coupled to a first power supply system, a base having a first input signal having a first frequency and a first bias signal, and a collector; a second transistor having an emitter coupled to the first power supply system, a base having a second input signal having a second frequency and a second bias signal, and a collector; a third transistor having an emitter connected to the collectors of the first and second transistors, a base receiving a third bias signal; and a collector via which an output signal is obtained; a load element connected between the collector of the third transistor and a second power supply system; and a first capacitor connected between the base of the third transistor and the first power supply system.

BRIEF DESCRIPTION OF THE DRAWINGS

Other objects, features and advantages of the present invention will become apparent from the following detailed description when read in conjunction with the accompanying drawings, in which:

FIG.1 is a circuit diagram of a first conventional frequency conversion circuit;

FIG.2 is a circuit diagram of a second conventional frequency conversion circuit;

FIG.3 is a circuit diagram of a third conventional frequency conversion circuit;

FIG.4 is a circuit diagram of a fourth conventional frequency conversion circuit;

FIG.5 is a circuit diagram of an outline of the present invention;

FIG.6 is a circuit diagram of a first preferred embodiment of the present invention;

FIG.7 is a circuit diagram of a circuit of the present invention used in the experiments;

FIG.8 is a circuit diagram of a measurement system used in the experiments;

FIGS.9A, 9B and 9C are graphs showing the results of the experiments;

FIGS.10A and 10B are graphs showing the results of the experiments in which the characteristics of the second conventional circuit shown in FIG.2 were measured;

FIGS.11A and 11B are circuit diagrams of a second preferred embodiment of the present invention;

FIG.12 is a circuit diagram of a third preferred embodiment of the present invention;

FIGS.13A and 13B are circuit diagrams of a fourth preferred embodiment of the present invention;

FIG.14 is a circuit diagram of a fifth preferred embodiment of the present invention;

FIG.15 is a circuit diagram of a practical application of the present invention;

FIG.16 is a circuit diagram of a variation of the first preferred embodiment of the present invention shown in FIG.6; and

FIG.17 is a block diagram of a signal receiver part of a radio communication system to which the present invention is applied.

DESCRIPTION OF THE PREFERRED EMBODIMENTS

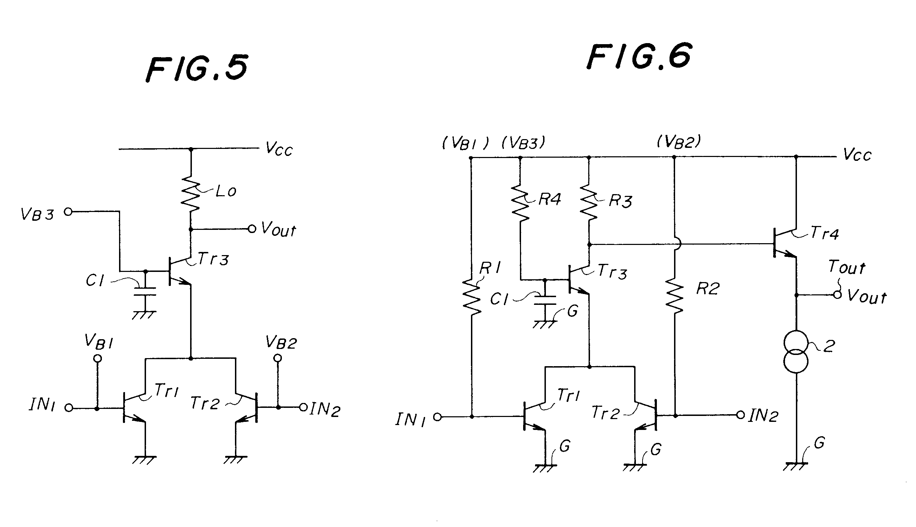

Referring to FIG.5, the frequency conversion circuit of the present invention is composed of three npn transistors Tr1, Tr2 and Tr3, a load element Lo, such as a resistor, and a capacitor C1. Input signals IN1 and IN2 having different frequencies are applied to the bases of the transistors Tr1 and Tr2, respectively. Predetermined bias voltages $V_{B1}$ and $V_{B2}$ are applied to the bases of the transistors Tr1 and Tr2, respectively. The emitters of the transistors Tr1 and Tr2 are grounded. The collectors of the transistors Tr1 and Tr2 are connected to the emitter of the transistor Tr3. The base of the transistor Tr3 is grounded via the capacitor C1, and supplied with a fixed bias voltage $V_{B3}$. A power supply voltage Vcc is applied to the collector of the transistor Tr3 via the load element Lo. An output signal Vout is obtained at the collector of the transistor Tr3.

The input signals IN1 and IN2 are amplified by the transistors Tr1 and Tr2, respectively, and mixed with each other by the transistor Tr3. The output signal Vout has a first signal component having a frequency equal to the sum of the frequencies of the input signals IN1 and IN2 and a second signal component having a frequency equal to the difference between the frequencies of the input signals IN1 and IN2.

The transistor Tr3 which has the frequency fixing function is provided separately from the transistors Tr1 and Tr2 which receive the input signals IN1 and IN2. The transistor Tr3 serves as a buffer which receives the amplified input signals IN1 and IN2 from the transistors Tr1 and Tr2. Hence, the circuit configuration shown in FIG.5 is made difficult to oscillate.

As the base of the transistor Tr3 is grounded via the capacitor C1, the impedance of the emitter of the transistor Tr3 is low with respect to the impedances of the collectors of the transistors Tr1 and Tr2. Even if the collector current of the transistor Tr3 varies greatly, the voltage drop developed between the base and emitter of the transistor Tr3 is fixed. Hence, all the amplified input signals IN1 and IN2 obtained at the collectors of the transistors Tr1 and Tr2 are received by the emitter of the transistor Tr3. In this manner, the interference between the transistors Tr1 and Tr2 can be suppressed, and hence the isolation between the input signals IN1 and IN2 can be improved.

Since the circuit configuration shown in FIG.5 uses three bipolar transistors, it has a low noise figure than that of the circuit configuration shown in FIG.2. In addition, the circuit configuration shown in FIG.5 is less expensive than that shown in FIG.2.

Two transistors are connected in series between the Vcc line and the ground as shown in FIG.5, the circuit shown in FIG.5 can operate by a lower power supply voltage than that for the circuit shown in FIG.2.

FIG.6 is a circuit diagram of a first preferred embodiment of the present invention. In FIG.6, those parts which are the same as those shown in FIG.5 are given the same reference numerals. A resistor R3, which is connected between the collector of the transistor Tr3 and the Vcc line, corresponds to the load element Lo shown in FIG.5. A resistor R1 is connected between the base of the transistor Tr1 and the Vcc line, and a resistor R2 is connected between the base of the transistor Tr2 and the Vcc line. The bias voltage $V_{B1}$ applied to the base of the transistor Tr1 is generated by the resistor R1, and the bias voltage $V_{B2}$ applied to the base of the transistor Tr2 is generated by the resistor R2. A resistor R4 is connected between the base of the transistor Tr3 and the Vcc line. The bias voltage $V_{B3}$ is generated by the resistor R4.

The output voltage obtained at the collector of the transistor Tr3 is amplified by an npn transistor Tr4, which has a base connected to the collector of the transistor Tr3, a collector connected to the Vcc line, and an emitter connected to the output terminal Tout. It will be noted that the collector of the transistor Tr3 has a high impedance and the emitter of the transistor Tr4 has a low impedance. That is, the output signal Vout is output to a subsequent-stage circuit (not shown) in the low-impedance state. The output signal Vout of the frequency conversion circuit shown in FIG.6 is output via the output terminal Tout. The output signal Vout includes a first signal component having a frequency equal to the sum of the frequencies of the input signals IN1 and IN2 and a second signal component having a frequency equal to the difference between the frequencies of the input signals IN1 and IN2. A constant-current source 2 is connected between the emitter of the transistor Tr4 and the ground G.

For example, the values of the circuit elements shown in FIG.6 are as follow: R1 = R2 = 150kΩ, R3 = 200Ω, R4 = 33kΩ and C1 = 120pF.

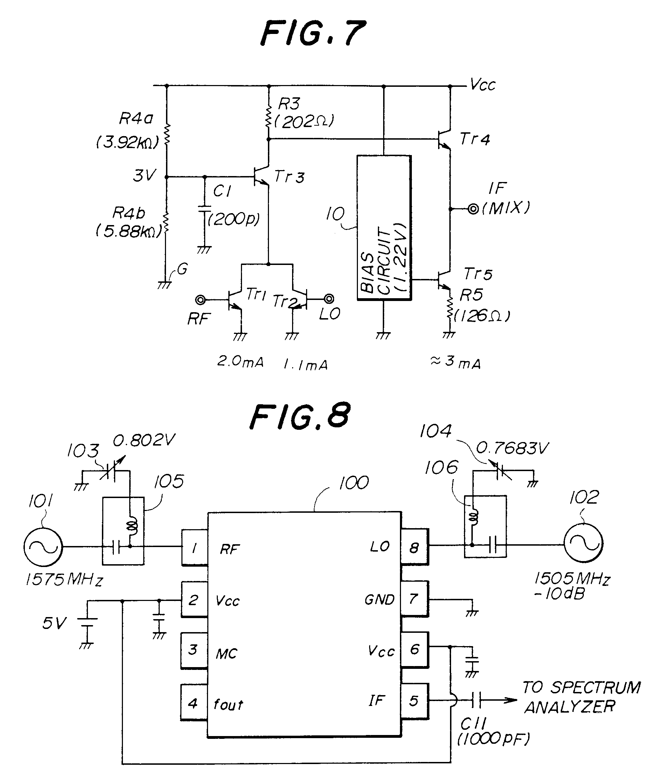

FIG.7 is a circuit diagram of a frequency conversion circuit used in experiments. The bias voltage $V_{B3}$ applied to the base of the transistor Tr3 is generated by resistors R4a and R4b connected in series between the Vcc line and the ground. A transistor Tr5 and a resistor R5 form the constant-current circuit 2 shown in FIG.6. Reference "RF" corresponds to the input signal IN1, and reference "LO" corresponds to the input signal IN2. Reference "IF" corresponds to the output signal Vout. The resistors R3, R4a, R4b and R5 have resistance values shown in FIG.7, and the capacitor C1 has a capacitance of 200pF. A bias circuit 10 generates a bias voltage of 1.22V from the power supply voltage Vcc.

FIG.8 is a circuit diagram of an experimental system. An IC chip 100 includes the circuit shown in FIG.7, and eight terminals #1 - #8. An oscillator 101 generates a signal having a frequency of 1575MHz. The signal generated by the oscillator 101 is applied to terminal #1 via an LC circuit 105, which is biased by a variable DC source 103. An oscillator 102 generates a signal having a frequency of 1505MHz, which is applied to terminal #8 via an LC circuit 106 biased by a variable DC source 104. As shown, the variable DC source 103 generates a DC voltage VRF of 0.802V, and the variable DC source 104 generates a DC voltage of 0.7683V. A spectrum analyzer (not shown) is coupled to terminal #5 via a capacitor C11 having a capacitance of 1000pF.

The conditions of measurement are as follows: RF signal frequency: 1575MHz LO signal frequency: 1505MHz, -10dBm IF signal frequency: 70MHz.

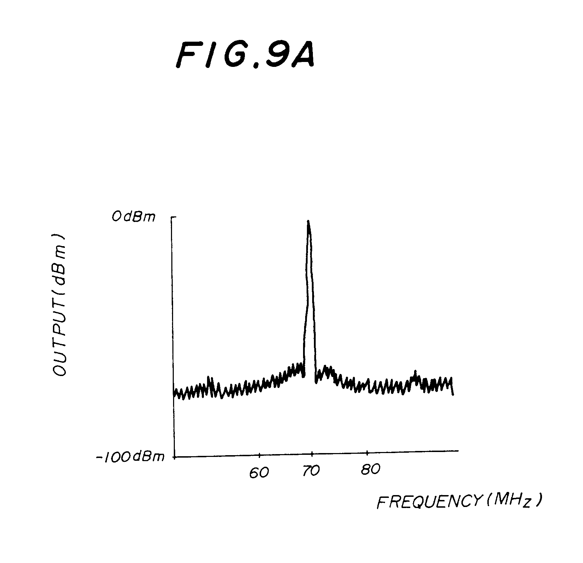

FIG.9A is a waveform diagram of the IF signal analyzed by the spectrum analyzer. It can be seen from FIG.9A that the IF signal has a frequency of 70MHz.

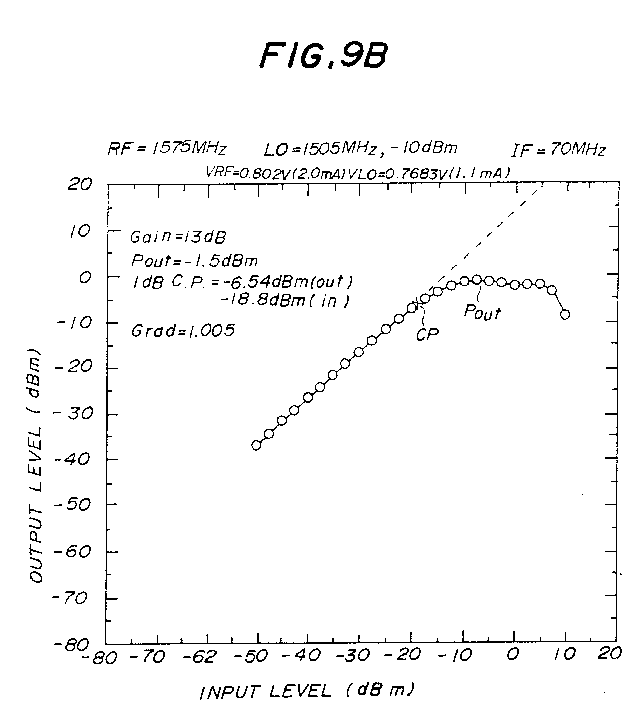

FIG.9B is a graph showing a change in the output level of the 70MHz IF signal as the input level of the RF signal is changed in the state where the -10dBm LO signal having a frequency of 1505MHz is applied to terminal #8 (FIG.8). The conversion gain of the circuit shown in FIG.7 is equal to 13dB, and the output power (peak power: Pout) thereof is equal to -1.5dBm. A 1dB compression point CP, which shows linearity of the circuit is at an output level of -6.54dBm and an input level of -18.8dBm.

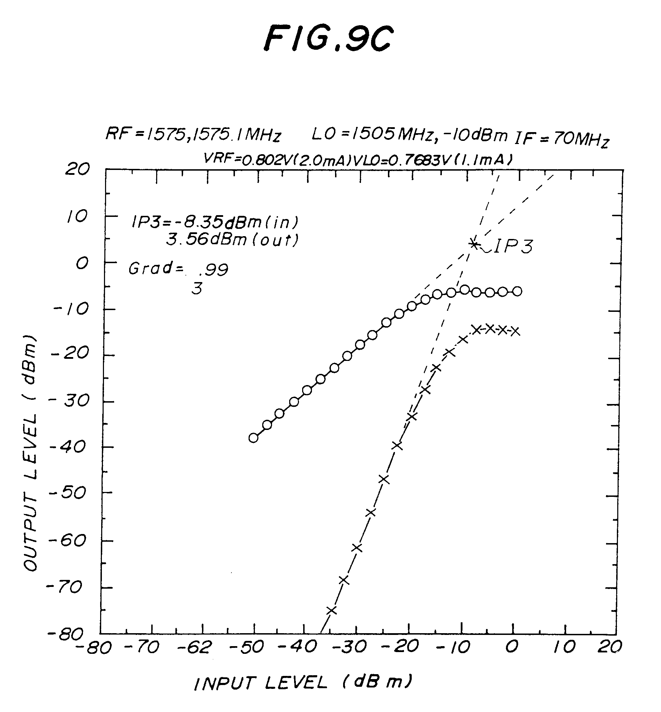

FIG.9C is a graph of input-output characteristics obtained when two RF signals respectively having frequencies of 1575MHz and 1575.1MHz are input to terminal #1. In this case, unwanted signal components plotted by crosses "x" appear in addition to the regular IF signal plotted by circles. Such unwanted signal components have frequencies (2f2 - f1) - f3 and (2f1 - f2) - f3 where f1 and f2 are the frequencies of the two RF signals, and f3 is the frequency of the LO signal. An intersect point IP3 where extension lines along linear portions of the two curves cross each other is at an output level of -8.35dBm and an input level of 3.56dBm.

Further, an isolation level from the RF signal side to the LO signal side is equal to -10dB, and an isolation level from the LO signal side to the RF signal side is equal to -15dB.

It can be seen from the above that the frequency conversion circuit shown in FIG.7 has good frequency conversion characteristics.

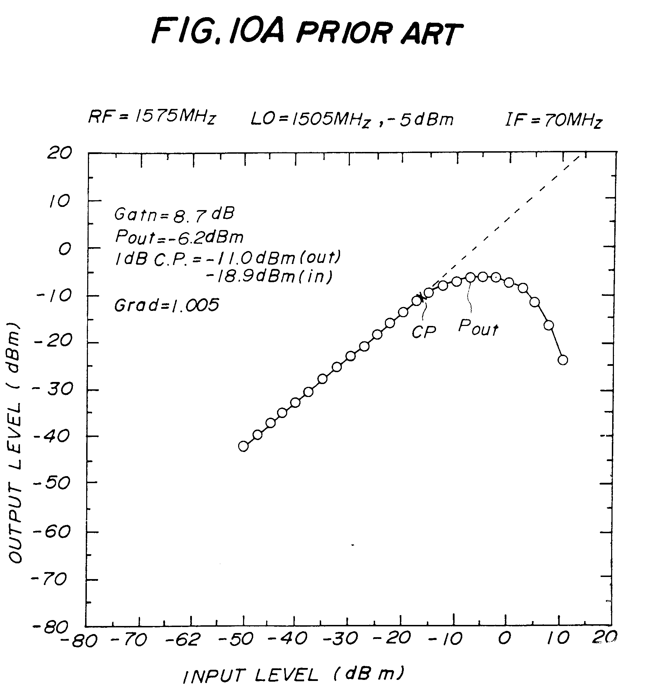

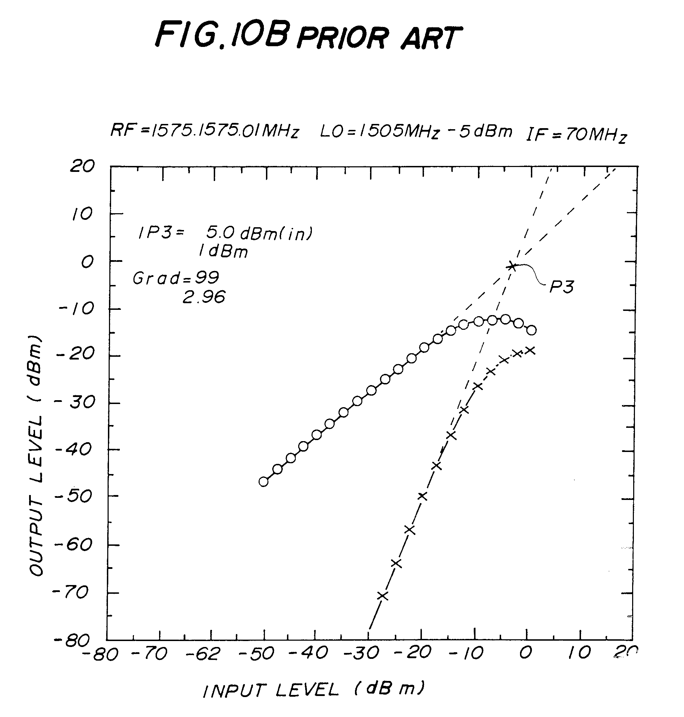

FIGS.10A and 10B, which correspond to FIGS.9B and 9C, respectively, are graphs showing the characteristics of the second conventional circuit shown in FIG.2. The conditions of measurements are the same as described previously except that the LO signal is at -5dBm.

The conversion gain of the circuit shown in FIG.2 is equal to 8.7dB, and the output power (peak power: Pout) thereof is equal to -6.2dBm. The 1dB compression point CP is at an output level of -11.0dBm and an input level of -18.9dBm.

In FIG.10B, unwanted signal components plotted by crosses "x" appear in addition to the regular IF signal plotted by circles. Such unwanted signal components have frequencies (2f2 - f1) - f3 and (2f1 - f2) - f3 where f1 and f2 are the frequencies of the two RF signals, and f3 is the frequency of the LO signal. The intersect point IP3 where extension lines along linear portions of the two curves cross each other is at an output level of 0.1dBm and an input level of -5.9dBm.

Further, the isolation level from the RF signal side to the LO signal side is equal to -27.2dB, and the isolation level from the LO signal side to the RF signal side is equal to -21.5dB.

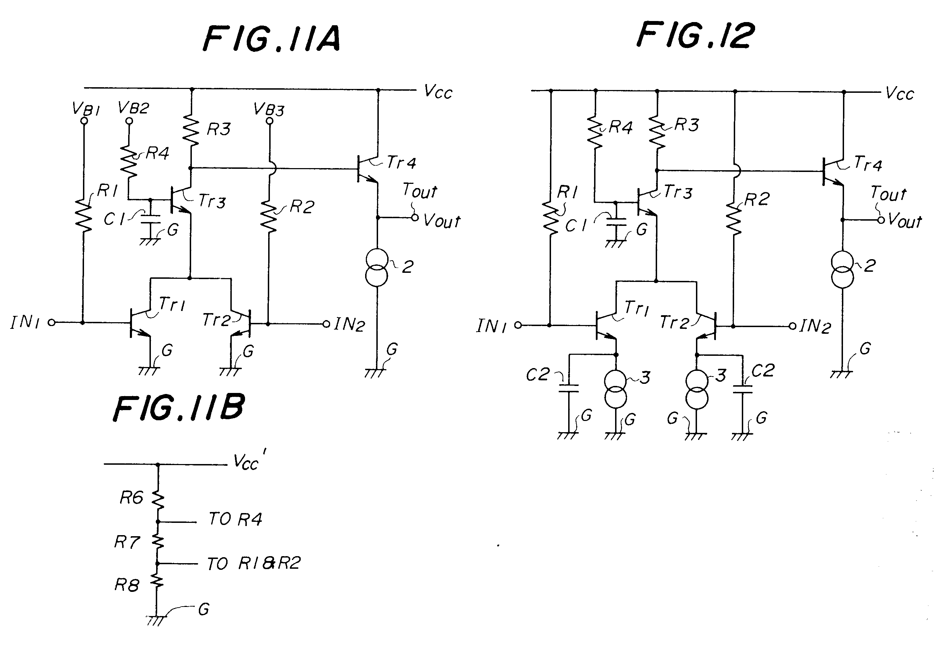

FIG.11A is a circuit diagram of a second preferred embodiment of the present invention. In FIG.11, those parts which are the same as those shown in the previously described figures are given the same reference numerals. The bias voltages $V_{B1}$, $V_{B2}$ and $V_{B3}$ respectively applied to the bases of the transistors Tr1, Tr2 and Tr3 are not generated from the power supply line Vcc but generated from a bias voltage generator separately from the power supply voltage Vcc. There is a possibility that in the circuit configuration shown in FIG.6, the bias voltages $V_{B1}$, $V_{B2}$ and $V_{B3}$ will vary if an AC component is superimposed on the Vcc line of the configuration shown in FIG.6. In this case, variations in the bias voltages $V_{B1}$, $V_{B2}$ and $V_{B3}$ are forward backed, and hence the circuit will oscillate. The circuit shown in FIG.11A does not have the above possibility.

FIG.11B shows an example of the bias voltage generator. A resistor network consisting of resistors R6, R7 and R8 connected in series is connected between a Vcc' power supply line and the ground G. The Vcc' power supply line is a power supply system separated from the Vcc power supply line. A node where the resistors R6 and R7 are connected in series is connected to the resistor R4, and a node where the resistors R7 and R8 are connected in series is connected to the resistors R1 and R2.

For example, the values of the circuit elements shown in FIG.11A are as follows: R1 = R2 = 150kΩ, R3 = 200Ω, R4 = 1kΩ, and C1 = 120pF.

FIG.12 is a circuit diagram of a third preferred embodiment of the present invention. In FIG.12, those parts which are the same as those shown in the previous figures are given the same reference numerals. The emitters of the transistors Tr1 and Tr2 are grounded via constant-current sources 3. The constant-current sources 3 suppress variations in the collector currents of the transistors Tr1 and Tr2 from varying due to change in ambient temperature. AC signal components pass through the capacitors C2. With the above-mentioned arrangement, it becomes possible to improve the temperature characteristic of the circuit without degrading the high-frequency characteristic.

For example, the values of the circuit elements shown in FIG.12 are as follows: R1 = R2 = 150kΩ, R3 = 200Ω, R4 = 33kΩ, C1 = 60pF and C2 = 30pF.

FIG.13A is a circuit diagram of a fourth preferred embodiment of the present invention. In FIG.13A, those parts which are the same as those shown in the previous figures are given the same reference numerals. An inductor L2 is substituted for the resistor R3 shown in FIG.6, and a series resonance circuit composed of an inductor L1 and a capacitor C3 is substituted for the capacitor C1. The power supply voltage Vcc is applied to the collector of the transistor Tr3 without any voltage drop. Thus, the circuit shown in FIG.13 has improved characteristics, as compared with the circuit shown in FIG.6. The series resonance circuit composed of the inductor L1 and the capacitor C3 has an impedance of zero at a resonant frequency. In this state, the amplifying characteristics of the transistor Tr3 are enhanced since the base thereof is directly grounded. As shown in FIG.13B, it is also possible to replace the inductor L2 by a parallel resonance circuit composed of an inductor L12 and a capacitor C12.

For example, the values of the circuit elements shown in FIG.13 A are as follows: R1 = R2 = 150kΩ, R4 = 33kΩ, L1 = L2 = 0.1μH, and C3 = 120pF.

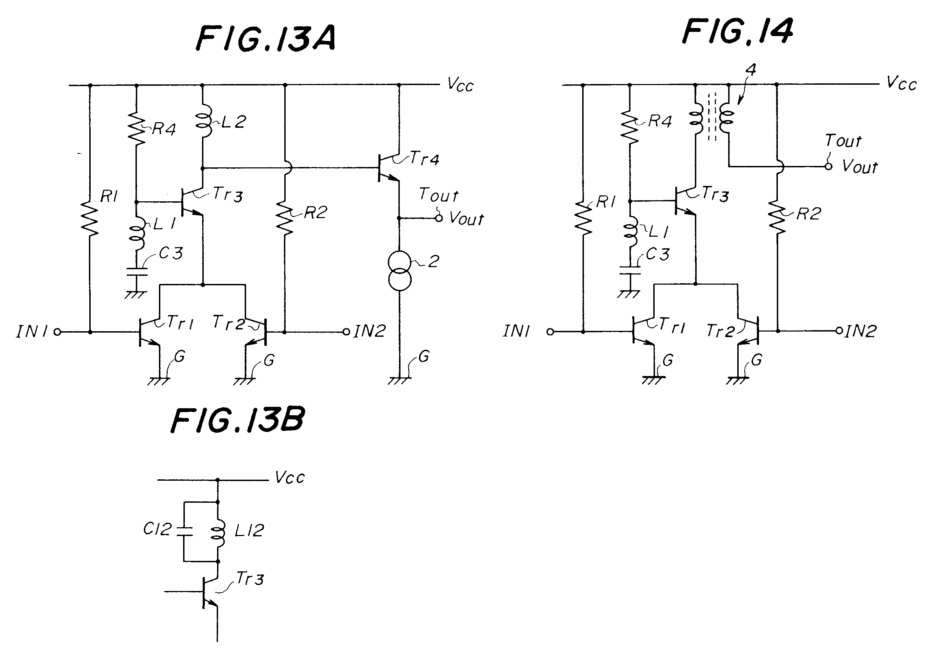

FIG.14 is a circuit diagram of a fifth preferred embodiment of the present invention. In FIG.14, those parts which are the same as those shown in the previous figures are given the same reference numerals. A transformer 4, which is substituted for the inductor L2 and the transistor Tr4 shown in FIG.13, functions as an impedance conversion element. The transformer 4 has a primary winding connected to the collector of the transistor Tr3 and the Vcc line, and a secondary winding connected to the Vcc line and the output terminal Tout. The transformer 4 converts a high impedance of the collector of the transistor Tr3 into a low impedance equal to, for example, 50Ω.

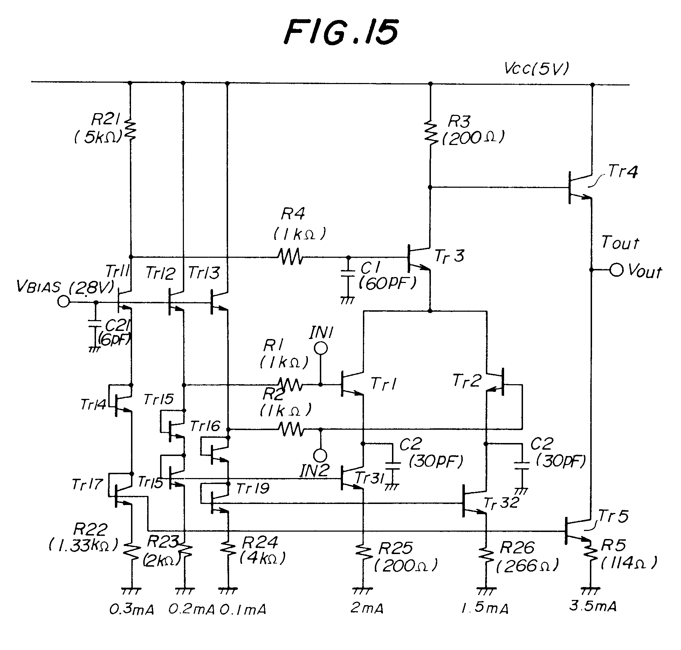

FIG.15 is a circuit diagram of a practical application of the frequency conversion circuit of the present invention. In FIG.15, those parts which are the same as those shown in the previous figures are given the same reference numerals. A transistor Tr31 and a resistor R25 form the constant-current source 3 (FIG.12) connected to the emitter of the transistor Tr1. Similarly, the constant-current source 3 connected to the emitter of the transistor Tr2 is composed of a transistor Tr32 and a resistor R26. The transistor Tr5 and the resistor R5 form the constant-current source shown in FIG.12.

Transistors Tr11 - Tr19, resistors R21 - R24 and a capacitor C21 form a bias generator, which generates the bias voltages $V_{B1}$, $V_{B2}$ and $V_{B3}$, and other bias voltages which will be described later. A predetermined bias voltage $V_{BIAS}$ equal to, for example, 2.8V, is applied to the bases of the transistors Tr11 - Tr13, which are grounded via the capacitor C21. A series circuit composed of diode-connected transistors Tr14 and Tr17 is connected to the emitter of the transistor Tr11, and grounded via the resistor R22. A series circuit composed of diode-connected transistors Tr15 and Tr18 is connected to the emitter of the transistor Tr12, and grounded via the resistor R23. A series circuit composed of diode-connected transistors Tr16 and Tr19 is connected to the emitter of the transistor Tr13, and grounded via the resistor R24. It should be noted that the bias voltages $V_{B1}$, $V_{B2}$ and $V_{B3}$ are not affected by variations in the power supply voltage Vcc (5V). The collectors of the transistors Tr15 and Tr16 are coupled to the bases of the transistors Tr1 and Tr2 via the resistors R1 and R2, respectively. Bias voltages applied to the bases of the transistors Tr31, Tr32 and Tr5 are generated at the collectors of the transistors Tr17, Tr18 and Tr19.

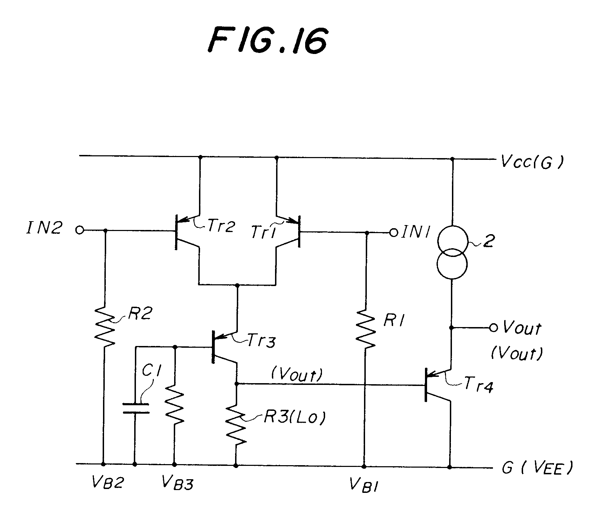

FIG.16 is a variation of the first embodiment of the present invention shown in FIG.6. The npn transistors Tr1 - Tr4 shown in FIG.6 are replaced by pnp transistors. The circuit shown in FIG.16 operate in the same manner as the circuit shown in FIG.6. The circuit shown in FIG.16 is connected to the Vcc line (high-potential side) and the ground G. It is also possible to use a high-potential side power supply voltage equal to the ground level and a low-potential side power supply voltage $V_{EE}$ lower than the ground potential. It is possible to configure the other embodiments of the present invention by using pnp transistors.

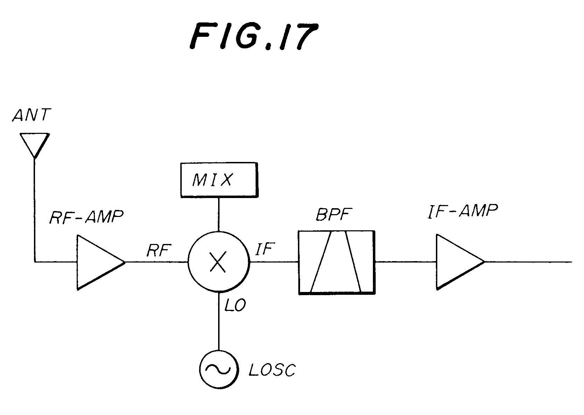

The present invention can be applied to, for example, a radio communication device in a manner as shown in FIG.17, which shows a signal receiver part thereof. The signal receiver part is composed of an antenna ANT, a high-frequency low-noise amplifier RF-AMP, a mixer MIX, a local oscillator LOSC, a bandpass filter BPF and an intermediate frequency amplifier IF-AMP. The mixer MIX corresponds to the frequency conversion circuit of the present invention. The aforementioned RF signal via the high-frequency amplifier RF-AMP is applied to the mixer MIX, while the LO signal generated by the local oscillator LOSC is applied to the mixer MIX. Then, the mixer MIX generates an IF (Intermediate Frequency) signal composed of a first signal component having a frequency equal to the sum of the frequencies of the RF signal and the LO signal and a second signal component having a frequency equal to the difference therebetween. The bandpass filter BPF functions to pass either the first signal component or the second signal component. The selected signal component is amplified by the intermediate frequency amplifier IF-AMP, and then supplied to a low-frequency amplifier (not shown) to which a speaker (not shown) is coupled.

When the present invention is applied to a portable telephone set, the RF signal has a frequency of, for example, 870MHz, and the LO signal has a frequency of, for example, 780MHz. In this case, the IF signal has two frequency components of 90MHz and 1650MHz. The bandpass filter BPF passes only the 90MHz signal component.

The present invention is not limited to the specifically disclosed embodiments, and variations and modifications may be made without departing from the scope of the present invention.

**Claims**

1. A frequency conversion circuit comprising:

a first transistor (Tr1) having an emitter coupled to a first power supply system (G, $V_{EE}$), a base having a first input signal (IN1, RF) having a first frequency and a first bias signal ($V_{B1}$), and a collector;

a second transistor (Tr2) having an emitter coupled to the first power supply system, a base having a second input signal (IN2, LO) having a second frequency and a second bias signal ($V_{B2}$), and a collector;

a third transistor (Tr3) having an emitter connected to the collectors of the first and second transistors, a base receiving a third bias signal ($V_{B3}$); and a collector via which an output signal (Vout, IF) is obtained;

a load element (Lo, R3) connected between the collector of the third transistor and a second power supply system (Vcc, G); and

a first capacitor (C1, C3) connected between the base of the third transistor and the first power supply system.

2. A frequency conversion circuit as claimed in claim 1, characterized in that said frequency conversion circuit comprises:

a fourth transistor (Tr4) having a base connected to the collector of the third transistor, a collector connected to the second power supply system, and an emitter; and

a constant-current source (2) connected between the emitter of the fourth transistor and the first power supply system, an amplified version of the output signal being obtained via the collector of the fourth transistor.

3. A frequency conversion circuit as claimed in claim 1, characterized in that the emitters of the first and second transistors are directly connected to the first power supply system.

4. A frequency conversion circuit as claimed in claim 1, characterized in that said frequency conversion circuit comprises:

a first resistor (R1) connected between the base of the first transistor and the second power supply system, the first bias signal being generated by the first resistor;

a second resistor (R2) connected between the base of the second transistor and the second power supply system, the second bias signal being generated by the second resistor; and

a third resistor (R4) connected between the base of the third transistor and the second power supply system, the third bias signal being generated by the third resistor.

5. A frequency conversion circuit as claimed in claim 1, characterized in that said load element comprises a resistor.

6. A frequency conversion circuit as claimed in claim 1, characterized in that said frequency conversion circuit comprises means (R6-R8), coupled between a third power supply system (Vcc') and the first power supply system, for generating said first, second and third bias signals from third third power supply system.

7. A frequency conversion circuit as claimed in claim 1, characterized in that:

said frequency conversion circuit comprises a resistor network (R6-R8) connected between a third power supply system (Vcc') and the first power supply system (G); and

said resistor network generates said first, second and third bias signals.

8. A frequency conversion circuit as claimed in claim 1, characterized in that said frequency conversion circuit comprises:

a first constant-current source (3) connected between the emitter of the first transistor and the first power supply system;

a second capacitor (C2) connected between the emitter of the first transistor and the first power supply system;

a second constant-current source (3) connected between the emitter of the second transistor and the first power supply system; and

a third capacitor (C2) connected between the emitter of the second transistor and the first power supply system.

9. A frequency conversion circuit as claimed in claim 1, characterized in that said frequency conversion circuit comprises an inductor (L1) connected to said first capacitor (C3) in series, so that a series resonance circuit is connected between the base of the third transistor and the first power supply system.

10. A frequency conversion circuit as claimed in claim 1, characterized in that said load element comprises an inductor (L2).

11. A frequency conversion circuit as claimed in claim 1, characterized in that:

said frequency conversion circuit comprises a first inductor (L1) connected to said first capacitor (C3) in series, so that a series resonance circuit is connected between the base of the third transistor and the first power supply system; and

said load element comprises a second inductor (L2).

12. A frequency conversion circuit as claimed in claim 1, characterized in that said load element comprises a parallel resonance circuit composed of an inductor (L12) and a second capacitor (C12).

13. A frequency conversion circuit as claimed in claim 1, characterized in that said load element comprises a transformer having a primary winding connected to the collector of the third transistor and the second power supply system, and a second winding via which an impedance-converted version of the output signal is obtained.

14. A frequency conversion circuit as claimed in claim 13, characterized in that said frequency conversion circuit comprises an inductor (L1) connected to said first capacitor (C3) in series, so that a series resonance circuit is connected between the base of the third transistor and the first power supply system.

15. A frequency conversion circuit as claimed in claim 1, characterized in that said frequency conversion circuit comprises:

a fourth transistor (Tr4) having a base connected to the collector of the third transistor, a collector connected to the second power supply system, and an emitter;

a first constant-current source (2) connected between the emitter of the fourth transistor and the first power supply system, an amplified version of the output signal being obtained via the collector of the fourth transistor;

a first resistor (R1) connected between the base of the first transistor and the second power supply system, the first bias signal being generated by the first resistor;

a second resistor (R2) connected between the base of the second transistor and the second power supply system, the second bias signal being generated by the second resistor; and

a third resistor (R4) connected between the base of the third transistor and the second power supply system, the third bias signal being generated by the third resistor.

16. A frequency conversion circuit as claimed in claim 1, characterized in that said frequency conversion circuit comprises:

a fourth transistor (Tr4) having a base connected to the collector of the third transistor, a collector connected to the second power supply system, and an emitter;

a first constant-current source (2) connected between the emitter of the fourth transistor and the first power supply system, an amplified version of the output signal being obtained via the collector of the fourth transistor;

a first resistor (R1) connected between the base of the first transistor and the second power supply system, the first bias signal being generated by the first resistor;

a second resistor (R2) connected between the base of the second transistor and the second power supply system, the second bias signal being generated by the second resistor;

a third resistor (R4) connected between the base of the third transistor and the second power supply system, the third bias signal being generated by the third resistor;

a second constant-current source (3) connected between the emitter of the first transistor and the first power supply system;

a second capacitor (C2) connected between the emitter of the first transistor and the first power supply system;

a third constant-current source (3) connected between the emitter of the second transistor and the first power supply system; and

a third capacitor (C2) connected between the emitter of the second transistor and the first power supply system.

17. A frequency conversion circuit as claimed in claim 1, characterized in that said frequency conversion circuit comprises:

a fourth transistor (Tr4) having a base connected to the collector of the third transistor, a collector connected to the second power supply system, and an emitter;

a first constant-current source (2) connected between the emitter of the fourth transistor and the first power supply system, an amplified version of the output signal being obtained via the collector of the fourth transistor;

a second constant-current source (Tr31, R25) connected between the emitter of the first transistor and the first power supply system, a first current generated by the second constant-current source being adjusted by a first control signal;

a second capacitor (C2) connected between the emitter of the first transistor and the first power supply system;

a third constant-current source (Tr32, R26) connected between the emitter of the second transistor and the first power supply system, a second current generated by the third constant-current source being adjusted by a second control signal;

a third capacitor (C2) connected between the emitter of the second transistor and the first power supply system; and

signal generating means (Tr11-Tr19, R21-R24, C21), connected between the first and second power supply systems, for generating said first, second and third bias signals and said first and second control signals from the second power supply system.

18. A frequency conversion circuit as any one of claims 1 to 17, characterized in that each of said first, second and third transistors is an npn transistor.

19. A frequency conversion circuit as any one of claims 1 to 17, characterized in that each of said first, second and third transistors is a pnp transistor.

20. A frequency conversion circuit as any one of claims 1 - 19, characterized in that said output signal comprises a first signal component having a frequency equal to the sum of the first and second frequencies, and a second signal component having a frequency equal to the difference between the first and second frequencies.

# FIG.1 PRIOR ART

Vout

I

IN 1

IN 2

# FIG.4 PRIOR ART

# FIG.3 PRIOR ART

Vcc

Tout

Vout

IN 1

IN 2

G

IN1  IN2

Vcc

Tout

Vout

G

10

# FIG.2 PRIOR ART

FIG.5

FIG.6

# FIG.7

# FIG.8

# FIG.9A

## FIG,9B

RF = 1575MHz    LO = 1505MHz, -10dBm    IF = 70MHz

VRF=0.802V(2.0mA)VLO=0.7683V(1.1mA)

Gain=13dB
Pout=-1.5dBm
1dB C.P.=-6.54dBm(out)
        -18.8dBm(in)

Grad=1.005

CP

Pout

OUTPUT LEVEL (dBm)

INPUT LEVEL (dBm)

# FIG.9C

RF =1575,1575.1MHz    LO =1505MHz, −10dBm  IF =70MHz
VRF=0.802V(2.0mA)VLO=0.7683V(1.1mA)

IP3=−8.35dBm(in)
3.56dBm(out)

Grad= .99
3

*⸻IP3

OUTPUT LEVEL ( dBm)

INPUT LEVEL ( dB m)

16

# FIG.10A PRIOR ART

RF = 1575MHz    LO = 1505MHz , - 5dBm    IF = 70MHz

Gain = 8.7 dB
Pout = -6.2dBm
1dB C.P. = -11.0 dBm (out)
            -18.9dBm (in)
Grad = 1.005

17

# FIG.10B PRIOR ART

RF =1575.1575.01MHz   LO =1505MHz − 5 dBm   IF = 70MHz

IP3 =   5.0 dBm(in)
      1 dBm

Grad = 99
      2.96

P3

OUTPUT LEVEL ( dBm )

INPUT LEVEL ( dB m )

## FIG.11A

## FIG.11B

## FIG.12

EP 0 488 257 A1

FIG.13A

FIG.13B

FIG.14

EP 0 488 257 A1

FIG.15

FIG.16

# FIG.17

EP 0 488 257 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 7, no. 8 (E-152)(1153) 13 January 1983 & JP-A-57 166 706 ( SONY K.K. ) 14 October 1985 | 1-3,10, 15,20 | H03D7/12 |
| Y | * figures 5,6D * | 4,5,18, 19 | |
| A | * abstract * | 16,17 | |
| Y | GAAS IC SYMPOSIUM, NOV 12-14, 1985, MONTEREY, CALIFORNIA, TECHNICAL DIGEST November 1985, NEW YORK, USA pages 165 - 168; DAUTRICHE ET AL.: 'GaAs MONOLITHIC CIRCUITS FOR TV TUNERS' * page 165, right column, paragraph 3; figure 5 * | 4,5 | |
| Y | GB-A-2 073 983 (PIONEER ELECTRONIC CORPORATION) | 18,19 | |
| A | * page 2, line 30 - line 33; claim 6; figure 3 * | 12-14 | |
| A | PATENT ABSTRACTS OF JAPAN vol. 10, no. 205 (E-420)17 July 1986 & JP-A-61 048 205 ( SONY CORPORATION ) 8 March 1986 * abstract * | 6,7,17 | TECHNICAL FIELDS SEARCHED (Int. Cl.5) H03D |
| A | PATENT ABSTRACTS OF JAPAN vol. 14, no. 401 (E-971)30 August 1990 & JP-A-2 151 178 ( SONY CORPORATION ) 11 June 1990 * abstract * | 8,16,17 | |
| A | PATENT ABSTRACTS OF JAPAN (E-461)5 December 1986 & JP-A-61 159 893 ( NEC HOME ELECTRONICS LTD ) 19 July 1986 * abstract * | 11,14 | |

The present search report has been drawn up for all claims

| Place of search | Date of completion of the search | Examiner |
|---|---|---|
| THE HAGUE | 05 MARCH 1992 | PEETERS M.M.G. |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons
...............................................................................
& : member of the same patent family, corresponding
      document

EPO FORM 1503 03.82 (P0401)